# EUROPÄISCHE PATENTSCHRIFT

(11) **EP 0 936 629 B1**
(45) Veröffentlichungstag und Bekanntmachung des Hinweises auf die Patenterteilung: **13.09.2006**
(21) Anmeldenummer: 99101524.9
(22) Anmeldetag: 27.01.1999
(51) Int. Cl.: G11C 16/06, G11C 16/04, G11C 16/10

(54) **EEPROM und Verfahren zur Ansteuerung eines EEPROM**
EEPROM and method for controlling an EEPROM
EEPROM et procédé de commande d'une mémoire EEPROM

(30) Priorität: 12.02.1998 DE 19805787
(43) Veröffentlichungstag der Anmeldung: 18.08.1999
(73) Patentinhaber: Infineon Technologies AG, 81669 München (DE)
(72) Erfinder: Georgakos, Georg, 85447 Fraunberg (DE); Kasprick, Kai, D-01129 Dresden (DE); Peter, Jürgen, 85604 Zorneding (DE); Bloch, Martin, 82194 Gröbenzell (DE); Kern, Thomas, Dr., 81739 München (DE); Piorek, Thomas, 81377 München (DE)
(74) Vertreter: Jannig, Peter

(56) Entgegenhaltungen:
- EP-A- 0 704 851
- EP-A- 0 778 623
- US-A- 5 706 228

## Beschreibung

Die vorliegende Erfindung betrifft ein EEPROM gemäß dem Oberbegriff des Patentanspruchs 1 und ein Verfahren zur Ansteuerung eines EEPROM gemäß dem Oberbegriff des Patentanspruchs 5.

EEPROMs sind nichtflüchtige, elektrisch programmier- und löschbare Speicher. Kern einer jeden Speicherzelle eines EEPROM ist dessen Speichertransistor.

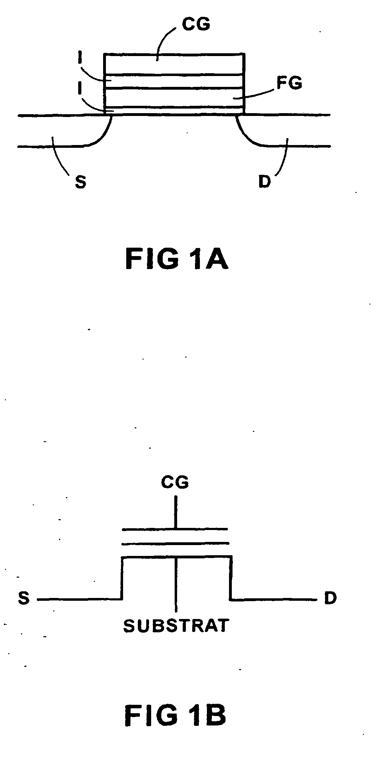

Der Aufbau eines zur Verwendung in einer integrierten Schaltung vorgesehenen Speichertransistors ist schematisch in Figur 1A dargestellt; das Schaltbild eines solchen Transistors ist in Figur 1B gezeigt.

Wie aus der Figur 1A ersichtlich ist, weist der dort gezeigte Speichertransistor wie "normale", d.h. nicht speichernde Transistoren einen in ein Substrat eingebetteten Sourceabschnitt S, einen ebenfalls in das Substrat eingebetteten Drainabschnitt D, und einen oberhalb des Substrats angeordneten (Steuer-)Gateabschnitt (Control Gate) CG auf. Im Unterschied zu den normalen Transistoren ist zwischen dem Substrat und dem Gateabschnitt CG zusätzlich ein von diesen durch Isolierschichten I elektrisch isoliertes sogenanntes Floating Gate FG vorgesehen.

Das zusätzliche Floating Gate FG wird unter bestimmten Umständen durch bestimmte Phänomene (beispielsweise CHE oder Fowler-Nordheim-Tunneln) aufgeladen oder entladen und behält den sich dabei einstellenden Ladezustand bis zum nächsten Lade- oder Entladevorgang bei. Die im Floating Gate des Speichertransistors gespeicherten Ladungen beeinflussen das Verhalten des Speichertransistors (insbesondere die Einsatzspannung desselben) und repräsentieren mithin eine dauerhafte (nichtflüchtige) und jederzeit ermittelbare (lesbare) Information.

Um zu verhindern, daß beim Lesen, Schreiben und/oder Löschen einer bestimmten Speicherzelle auch andere (benachbarte) Speicherzellen ausgelesen, beschrieben und/oder gelöscht werden, enthält jede Speicherzelle einen zweiten Transistor, genauer gesagt den bereits erwähnten Auswahltransistor, der durch einen "normalen" Transistor gebildet wird.

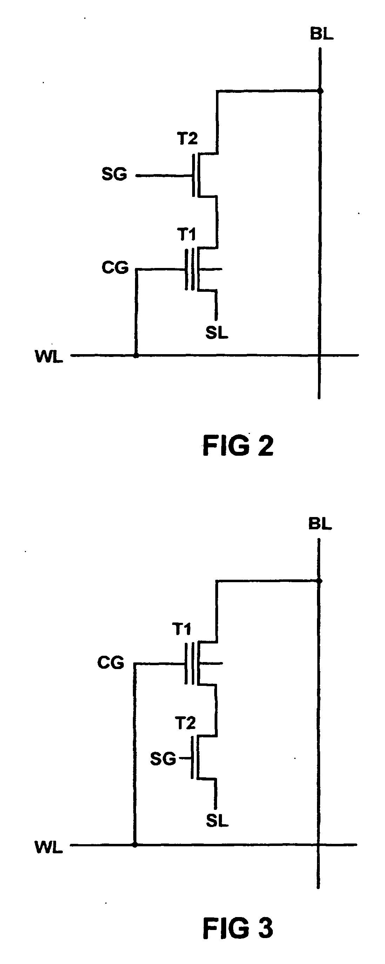

Der (nachfolgend mit T1 bezeichnete) Speichertransistor und der (nachfolgend mit T2 bezeichnete) Auswahltransistor waren ursprünglich wie in der Figur 2 veranschaulicht verschaltet.

Speicherzellen dieser Art sind über Auswahl-, Steuer-, Bit- und Sourceleitungen programmierbar, auslesbar und löschbar, wobei die Auswahlleitung mit dem Gateabschnitt SG des Auswahltransistors T2, die durch eine sogenannte Wortleitung WL gebildete Steuerleitung mit dem Steuergateabschnitt CG des Speichertransistors T1, die Bitleitung BL mit dem Drainabschnitt des Auswahltransistors T2 und die Sourceleitung SL mit dem Sourceabschnitt des Speichertransistors T1 verbunden sind.

Über die Auswahl-, Steuer-, Bit- und Sourceleitungen müssen beim Programmieren, Lesen und Löschen an die anzusprechenden (selektierten) und die nicht anzusprechenden (nicht selektierten) Speicherzellen typischerweise die in der folgenden Tabelle 1 aufgelisteten Spannungen (in Volt) angelegt werden:

**Tabelle 1**

| | CG | SG | BL | SL |
|---|---|---|---|---|
| Programmieren (selekt. / nicht selekt.) | -11 / 0 | 10 / -11 | 5 / 0 | 0 |
| Lesen | 2,5 | 5 | 1,5 | 0 |
| Löschen (selekt. / nicht selekt.) | 16 / 0 | 0 / 16 | 0 | 0 |

Wie aus der vorstehenden Tabelle 1 ersichtlich ist, muß der Auswahltransistor T2 beim Lesen die ihm über die Bitleitung BL zugeführte Lesespannung von 1,5 V zum Speichertransistor T1 durchschalten. Dazu ist am Gate SG des Auswahltransistors T2 eine relativ hohe Spannung erforderlich. Diese (ständig bzw. häufig benötigte) hohe Spannung verhindert, daß das EEPROM dem allgemeinen Bestreben folgend mit einer sehr niedrigen Versorgungsspannung betrieben werden kann; eine Absenkung der Versorgungsspannung unter 2,5 V ist jedenfalls nicht möglich.

Dieses Problem läßt sich lösen, wenn - wie im Aufsatz "A 2-Transistor Source-select (2TS) Flash EEPROM for 1,8 V - Only Applications" von Wei-Hua Liu et al. in IEEE Non-Volatile Semiconductor Memory Workshop, paper 4.1, 1997 vorgeschlagen - der Speichertransistor T1 und der Auswahltransistor T2 vertauscht werden, der Auswahltransistor T2 also an die Source-Seite des Speichertransistors T1 gesetzt wird.

Eine solche Speicherzelle ist in Figur 3 veranschaulicht.

Zum Programmieren, Lesen und Löschen müssen an die anzusprechenden (selektierten) und die nicht anzusprechenden (nicht selektierten) Speicherzellen über die Auswahl-, Steuer-, Bit- und Sourceleitungen typischerweise die in der folgenden

Tabelle 2 aufgelisteten Spannungen (in Volt) angelegt werden, wobei VDD die Versorgungsspannung des EEPROM repräsentiert:

**Tabelle 2**

| | CG | SG | BL | SL |
|---|---|---|---|---|
| Programmieren (selekt. Speicherzelle) | -12 | 0 | 5 | 0 |
| Programmieren (nicht selekt. Spalte) | -12 | 0 | 0 | 0 |
| Programmieren (nicht selekt. Reihe) | 3,5 | 0 | 0 | 0 |
| Lesen | 1 | VDD | 1 | 0 |
| Löschen | 14,5 | VDD | 0 | 0 |

Wie aus der vorstehenden Tabelle 2 ersichtlich und bei Betrachtung des in der Figur 3 gezeigten Aufbaus der betrachteten Speicherzelle nachvollziehbar ist, müssen durch den Auswahltransistor T2 beim Lesen "nur" noch die 0 V der Sourceleitung SL durchgeschaltet werden, wodurch die an den Gateanschluß SG des Auswahltransistors T2 anzulegende Spannung mit ca. 1 V (der sogenannten Thresholdspannung Vₜₕ) sehr niedrig sein kann.

Dadurch ist es möglich, EEPROMs mit niedrigen Versorgungsspannungen zu realisieren.

Allerdings gestaltet sich bei Speicherzellen gemäß Figur 3 das Programmieren derselben komplizierter. Beim Programmieren wird nämlich auch den Speichertransistoren der nicht selektierten Speicherzellen die Programmierspannung von 5 V über die Bitleitung zugeführt. Dies führt dort zu einer als Drain Disturb bezeichneten Störung, die sich darin äußert, daß auf den isolierten Floating Gates FG der Speichertransistoren eine Ladungsveränderung stattfindet, die bei entsprechend langer Dauer oder hoher Häufigkeit dazu führen kann, daß sich die aus den Speicherzellen auslesbare Information verändert, die gespeicherte Information also verlorengeht.

Dieser Effekt kann gemäß dem vorstehend erwähnten Aufsatz von Wei-Hua Liu et al. durch Anlegen einer Kompensationsspannung an die nicht selektierten Wortleitungen (siehe Tabelle 2) begrenzt werden; er kann dadurch jedoch nicht gänzlich zum Verschwinden gebracht werden, was erkennbar ein gravierender Nachteil ist.

In der EP 778 623 ist ein EEPROM beschrieben, in dem der Speichertransistor und der Auswahltransistor vertauscht sind und die Programmierspannung über die Sourceleitung gleichzeitig an alle Zellen angelegt wird. Das in der EP 778 623 beschriebene EEPROM und das in der EP 778 623 beschriebene Ansteuerverfahren sind ein EEPROM gemäß dem Oberbegriff des Patentanspruchs 1 bzw. ein Verfahren gemäß dem Oberbegriff des Patentanspruchs 5. Auch der EP 778 623 sind jedoch keine Hinweise zur Lösung der vorstehend angesprochenen Probleme entnehmbar.

Der vorliegenden Erfindung liegt daher die Aufgabe zugrunde, das EEPROM gemäß dem Oberbegriff des Patentanspruchs 1 und das Ansteuerverfahren gemäß dem Oberbegriff des Patentanspruchs 5 derart weiterzubilden, daß ungewollte Informationsverluste auf einfache Weise zuverlässig verhindert werden können.

Diese Aufgabe wird erfindungsgemäß durch die in Patentanspruch 1 beanspruchten Vorrichtung bzw. das in Patentanspruch 5 beanspruchte Verfahren gelöst.

Dadurch kann erreicht werden, daß die Programmierspannung nur noch an die Speichertransistoren derjenigen Speicherzellen gelangt, die durch den zugehörigen Auswahltransistor (mittels der diesen steuernden Auswahlleitung) ausgewählt sind. An Speichertransistoren von nicht ausgewählten Speicherzellen, genauer gesagt an den Floating Gates derselben kann daher beim Programmieren keine ungewollte Ladungsverschiebung mehr stattfinden, wodurch die im Speichertransistor gespeicherte Information auf denkbar einfache Weise dauerhaft erhalten werden kann.

Vorteilhafte Weiterbildungen der Erfindung sind den Unteransprüchen, der folgenden Beschreibung und den Zeichnungen entnehmbar.

Die Erfindung wird nachfolgend anhand eines Ausführungsbeispiels unter Bezugnahme auf die Zeichnung näher erläutert. Es zeigen
- Figur 1A: schematisch den Aufbau eines in den Speicherzellen des betrachteten EEPROMs verwendeten Speichertransistors,
- Figur 1B: das Schaltsymbol des Speichertransistors gemäß Figur 1A,
- Figur 2: den Aufbau einer herkömmlichen EEPROM-Speicherzelle, und
- Figur 3: eine gegenüber der Darstellung in der Figur 2 modifizierte Speicherzelle.

Das nachfolgend näher betrachtete EEPROM besteht wie herkömmlich EEPROMs aus einer Vielzahl von in Reihen und Spalten, d.h. matrixartig angeordneten Speicherzellen. Jede der Speicherzellen enthält einen Speichertransistor und einen Auswahltransistor, die wie in der Figur 3 gezeigt verschaltet sind.

D.h., der Speichertransistor T1 und der Auswahltransistor T2 sind in Reihe geschaltet, wobei der Auswahltransistor T2 an der Source-Seite des Speichertransistors T1 sitzt, und wobei die Auswahlleitung mit dem Gateabschnitt SG des Auswahltransistors T2, die durch die Wortleitung WL gebildete Steuerleitung mit dem Steuergateabschnitt CG des Speichertransistors T1, die Bitleitung BL mit dem Drainabschnitt des Speichertransistors T1, und die Sourceleitung SL mit dem Sourceabschnitt des Auswahltransistors T1 verbunden sind.

Allerdings liegt die mit dem Sourceanschluß des Auswahltransistors T2 verbundene Sourceleitung anders als bisher nicht mehr dauerhaft auf Massepotential, sondern ist dazu ausgelegt, auf andere Potentiale als 0 V gelegt zu werden.

Von dieser Möglichkeit wird im vorliegend betrachteten Beispiel beim Programmieren des EEPROM Gebrauch gemacht. Mit welchen Spannungen (in Volt) die selektierten und nicht selektierten Speicherzellen über die Auswahl-, Steuer-, Bit-und Sourceleitungen zum Programmieren, Lesen und Löschen vorzugsweise beaufschlagt werden, ist aus der folgenden Tabelle 3 ersichtlich, wobei VDD wiederum die Versorgungsspannung des EEPROM repräsentiert. Bei den zahlenmäßig angegebenen Spannungswerten möge berücksichtigt werden, daß es sich hierbei nur um Beispiele zur Veranschaulichung der ungefähren Größenordnungen und -verhältnisse handelt; die einzelnen Spannungen können unter anderem in Abhängigkeit von der verwendeten Technologie erheblich von den angegebenen Werten abweichen.

**Tabelle 3**

| | CG | SG | BL | SL |
|---|---|---|---|---|
| Programmieren (selekt. / nicht selekt.) | -11 / 0 | 10 / 0 | 0 | 5 / 0 |
| Lesen | VDD | VDD | 1,5 | 0 |
| Löschen (selekt. / nicht selekt.) | 16 / 0 | VDD | 0 | 0 |

Wie der Tabelle 3 entnehmbar ist, sind die den Speicherzellen beim Programmieren derselben über die Bitleitung(en) und die Sourceleitung(en) zugeführten Spannungen gegenüber der bisherigen Vorgehensweise in diesem Punkt gerad vertauscht.

D.h., die Programmierspannung wird der Speicherzelle nicht mehr über Bitleitung, sondern über die Sourceleitung zugeführt; die über die Bitleitung angelegte Spannung kann auf 0 V oder - allgemeiner ausgedrückt - sehr niedrige Spannung gesenkt werden.

Die niedrige Spannung, die dem Speichertransistor dabei über die direkt mit diesem verbundene Bitleitung zugeführt wird, kann im Speichertransistor, genauer gesagt dem Floating Gate desselben keine oder allenfalls vernachlässigbar geringe Ladungsveränderungen verursachen. Das Auftreten des erwähnten Drain Disturb oder ähnlicher Effekte, genauer gesagt deren Auslösung durch über die Bitleitung angelegte Spannungen ist damit ausgeschlossen.

Die (hohe) Spannung, die nunmehr über die Sourceleitung geführt wird, kann ebenfalls keine unerwünschten Störungen der genannten Art auslösen. Die Sourceleitung ist nämlich nicht direkt, sondern "nur" über den Auswahltransistor mit dem Speichertransistor verbunden, wodurch der Speichertransistor mit der über die Sourceleitung geleiteten Spannung nur beaufschlagt werden kann, wenn und so lange der Auswahltransistor in den leitenden Zustand versetzt ist (wenn und so lange die betreffende Speicherzelle über die mit dem Gateanschluß des Auswahltransistors verbundene Auswahlleitung ausgewählt ist). D.h., daß in den Speichertransistoren von nicht ausgewählten Speicherzellen auch die nunmehr über die Sourceleitung geführte hohe Spannung keine Ladungsveränderungen im Floating Gate hervorrufen kann.

Vorteilhaft am vorliegend betrachteten EEPROM bzw. dem vorliegend betrachteten Verfahren zur Ansteuerung eines EEPROMs ist ferner, daß die Programmierspannung nicht mehr über die selbe Leitung an die Speicherzelle angelegt werden muß wie die zum Auslesen des EEPROM erforderliche Lesespannung. Während nämlich die Programmierspannung nunmehr über die Sourceleitung geführt wird, wird die Lesespannung nach wie vor über die Bitleitung geführt (siehe die vorstehende Tabelle 3). Dies eröffnet die Möglichkeit, das Lesen und das Programmieren des EEPROM unabhängig voneinander zu optimieren. Dabei erweist es sich als vorteilhaft, wenn die Bitleitungen für kleine Spannungen und kurze Zugriffszeiten, und die Sourceleitung(en) für hohe Spannungen optimiert werden.

Insbesondere wenn die Speicherzellen nur in viele Speicherzellen umfassenden Einheiten (beispielsweise in Einheiten von langen Speicherzellen-Matrix-Reihen) auswählbar sind, erweist es sich als vorteilhaft, wenn die in der Regel für alle Speicherzellen gemeinsame Sourceleitung durch eine Vielzahl von separaten und unabhängig voneinander ansteuerbaren Sourceleitungen ersetzt wird, wobei jede der vielen Sourceleitungen nur einzelnen oder wenigen Speicherzellen (wenigen Speicherzellen innerhalb einer Speicherzellen-Matrix-Reihe) zugeordnet ist. Dadurch kann erreicht werden, daß von den Speicherzellen des betrachteten EEPROM selektiv einzelne Speicherzellen oder aus wenigen Speicherzellen bestehende Einheiten programmierbar sind.

Durch das vorstehend beschriebene EEPROM und das vorstehend beschriebene Verfahren zur EEPROM-Ansteuerung kann unabhängig von den Einzelheiten der praktischen Realisierung erreicht werden, daß ein mit niedriger Versorgungsspannung betreibbares EEPROM auf einfache Weise zuverlässig vor einem ungewollten Verlust der darin gespeicherten Informationen geschützt ist.

## Patentansprüche

1. EEPROM mit einer Vielzahl von Speicherzellen, die über Auswahl(SG)-, Steuer(CG)-, Bit(BL)- und Sourceleitungen (SL) programmierbar, auslesbar und löschbar sind,
- wobei die Speicherzellen jeweils einen Speichertransistor (T1) und einen zu diesem in Reihe geschalteten Auswahltransistor (T2) enthalten,
- wobei der Drainanschluß des Speichertransistors (T1) mit der Bitleitung (BL) und der Sourceanschluß des Auswahltransistors (T2) mit der Sourceleitung (SL) verbunden ist, und
- wobei eine Steuereinheit vorgesehen ist, die dazu ausgelegt ist, die zum Programmieren einer Speicherzelle erforderliche Programmierspannung über die Sourceleitung (SL) zuzuführen,
**dadurch gekennzeichnet,**
**daß** die Steuereinheit während des Programmierens von Speicherzellen sowohl die Bitleitungen (BL) der selektierten Speicherzellen als auch die Bitleitungen (BL) der nicht selektierten Speicherzellen mit im wesentlichen 0 V beaufschlagt.

2. EEPROM nach Anspruch 1,
**dadurch gekennzeichnet,**
**daß** für einzelne Speicherzellen oder Gruppen von Speicherzellen separate Sourceleitungen (SL) vorgesehen sind.

3. EEPROM nach Anspruch 1 oder 2,
**dadurch gekennzeichnet,**
**daß** die Sourceleitungen (SL) dazu ausgelegt sind, an die Speicherzellen hohe Spannungen anzulegen.

4. EEPROM nach einem der vorhergehenden Ansprüche,
**dadurch gekennzeichnet,**
**daß** die Steuereinheit dazu ausgelegt ist, die zum Auslesen einer Speicherzelle erforderliche Lesespannung über die Bitleitung (BL) zuzuführen.

5. Verfahren zur Ansteuerung eines EEPROM mit einer Vielzahl von Speicherzellen, die über Auswahl(SG)-, Steuer(CG)-, Bit(BL)- und Sourceleitungen (SL) programmierbar, auslesbar und löschbar sind,
- wobei die Speicherzellen jeweils einen Speichertransistor (T1) und einen zu diesem in Reihe geschalteten Auswahltransistor (T2) enthalten,
- wobei der Drainanschluß des Speichertransistors (T1) mit der Bitleitung (BL) und der Sourceanschluß des Auswahltransistors (T2) mit der Sourceleitung (SL) verbunden ist, und
- wobei die zum Programmieren einer Speicherzelle erforderliche Programmierspannung über die Sourceleitung (SL) zugeführt wird
**dadurch gekennzeichnet,**
**daß** während des Programmierens von Speicherzellen sowohl die Bitleitungen (BL) der selektierten Speicherzellen als auch die Bitleitungen (BL) der nicht selektierten Speicherzellen mit 0 V oder einer sehr niedrigen anderen Spannung beaufschlagt werden.

## Claims

1. EEPROM having a multiplicity of memory cells that are programmable, readable and erasable via select (SG), control (CG), bit (BL) and source lines (SL),
- the memory cells in each case containing a memory transistor (T1) and a selection transistor (T2) connected in series with the latter,
- the drain terminal of the memory transistor (T1) being connected to the bit line (BL) and the source terminal of the selection transistor (T2) being connected to the source line (SL), and
- a control unit being provided, which is designed to feed the programming voltage required for programming a memory cell via the source line (SL),
**characterized**
**in that** the control unit, during the programming of memory cells, applies essentially 0 V both to the bit lines (BL) of the selected memory cells and to the bit lines (BL) of the non-selected memory cells.

2. EEPROM according to Claim 1,
**characterized**
**in that** separate source lines (SL) are provided for individual memory cells or groups of memory cells.

3. EEPROM according to Claim 1 or 2,
**characterized**
**in that** the source lines (SL) are designed for applying high voltages to the memory cells.

4. EEPROM according to one of the preceding claims,
**characterized**
**in that** the control unit is designed for feeding the read voltage required for reading from a memory cell via the bit line (BL).

5. Method for driving an EEPROM having a multiplicity of memory cells that are programmable, readable and erasable via select (SG), control (CG), bit (BL) and source lines (SL),
- the memory cells in each case containing a memory transistor (T1) and a selection transistor (T2) connected in series with the latter,
- the drain terminal of the memory transistor (T1) being connected to the bit line (BL) and the source terminal of the selection transistor (T2) being connected to the source line (SL), and
- the programming voltage required for programming a memory cell being fed via the source line (SL),
**characterized**
**in that**, during the programming of memory cells, 0 V or some other voltage that is very low is applied both to the bit lines (BL) of the selected memory cells and to the bit lines (BL) of the non-selected memory cells.

## Revendications

1. EEPROM avec une multiplicité de cellules de mémoire, qui peuvent être programmées, lues et effacées par l'intermédiaire de lignes de sélection (SG), de commande (CG), de bit (BL) et de source (SL),
- les cellules de mémoire contenant chacune un transistor de mémorisation (T1) et un transistor de sélection (T2) branché en série avec celui-ci,
- le raccordement de drain du transistor de mémorisation (T1) étant relié à la ligne de bit (BL) et le raccordement de la source du transistor de sélection (T2) étant relié à la ligne de source (SL), et
- une unité de commande étant prévue pour acheminer la tension de programmation nécessaire pour programmer une cellule de mémoire par l'intermédiaire d'une ligne de source (SL),
**caractérisée en ce que** pendant la programmation de cellules de mémoire, l'unité de commande applique sensiblement 0 V à la ligne de bit (BL) des cellules de mémoire sélectionnées de même qu'à la ligne de bit (BL) des cellules de mémoire non sélectionnées.

2. EEPROM selon la revendication 1, **caractérisée en ce que** des lignes de source (SL) séparées sont prévues pour des cellules de mémoire individuelles ou pour des groupes de cellules de mémoire.

3. EEPROM selon la revendication 1 ou 2, **caractérisée en ce que** les lignes de source (SL) sont conçues pour appliquer des tensions élevées sur les cellules de mémoire.

4. EEPROM selon une des revendications précédentes, **caractérisée en ce que** l'unité de commande est conçue pour acheminer la tension de lecture nécessaire pour lire une cellule de mémoire par l'intermédiaire de la ligne de bit (BL).

5. Procédé pour la commande d'une EEPROM avec une multiplicité de cellules de mémoire, qui peuvent être programmées, lues et effacées par l'intermédiaire de lignes de sélection (SG), de commande (CG), de bit (BL) et de source (SL),
- les cellules de mémoire contenant chacune un transistor de mémorisation (T1) et un transistor de sélection (T2) branché en série avec celui-ci,
- le raccordement de drain du transistor de mémorisation (T1) étant relié à la ligne de bit (BL) et le raccordement de la source du transistor de sélection (T2) étant relié à la ligne de source (SL), et
- la tension de programmation nécessaire pour programmer une cellule de mémoire est acheminée par l'intermédiaire d'une ligne de source (SL),
**caractérisé en ce que** pendant la programmation de cellules de mémoire, on applique 0 V ou une autre tension très basse à la ligne de bit (BL) des cellules de mémoire sélectionnées de même qu'à la ligne de bit (BL) des cellules de mémoire non sélectionnées.
